# EUROPÄISCHE PATENTANMELDUNG

(11) **EP 3 527 686 A1**
(43) Veröffentlichungstag der Anmeldung: **21.08.2019**
(21) Anmeldenummer: 19156183.6
(22) Anmeldetag: 08.02.2019
(51) Int. Cl.: C23C 10/08, C23C 10/12, C23C 10/28, C23C 14/24, C23C 14/00, C23C 16/448, C23C 16/458

(54) **VORRICHTUNG UND VERFAHREN ZUM GASPHASENBESCHICHTEN VON WERKSTÜCKEN**

(30) Priorität: 15.02.2018 DE 102018202297
(71) Anmelder: MTU Aero Engines AG, 80995 München (DE)
(72) Erfinder: Walter, Heinrich, 86316 Friedberg (DE); Schneiderbanger, Stefan, 80996 München (DE); Pillhöfer, Horst, 85244 Röhrmoos (DE); Hilser, Ludwig, 80997 München (DE)

(57) **Zusammenfassung**

Die Erfindung betrifft eine Vorrichtung (10) zum Gasphasenbeschichten von Werkstücken (12). Die Vorrichtung (10) umfasst einen Beschichtungskasten (14), wenigstens zwei Werkstückauflagen (18) zum Anordnen der Werkstücke (12) in unterschiedlichen Niveaus des Beschichtungskastens (14), eine Halteeinrichtung (20), mittels welcher die wenigstens zwei Werkstückauflagen (18) in einem vorbestimmten Abstand zueinander im Beschichtungskasten (14) angeordnet sind, ein Deckelelement (30), mittels welchem der Beschichtungskasten (14) reversibel verschließbar ist und welches eine Öffnung (32) für eine Gaszuführungseinrichtung (34), mittels welcher ein Betriebsgas in den Beschichtungskasten (14) einbringbar ist, umfasst, und mindestens einen Behälter (36) für einen Spenderstoff, welcher beim Gasphasenbeschichten ein Beschichtungsgas bildet, wobei der mindestens eine Behälter (36) einen direkten Kontakt zwischen dem Spenderstoff und dem Beschichtungskasten (14) verunmöglicht. Die Erfindung betrifft weiterhin ein Verfahren zum Gasphasenbeschichten von Werkstücken (12).

## Beschreibung

Die Erfindung betrifft eine Vorrichtung und ein Verfahren zum Gasphasenbeschichten von Werkstücken.

Bei bekannten Vorrichtungen und Verfahren zum Gasphasenbeschichten von Werkstücken, beispielsweise von Turbinenbauteilen, werden diese in mehreren Beschichtungskästen angeordnet. Anschließend werden die einzelnen Beschichtungskästen übereinander gestapelt. Im untersten Beschichtungskasten wird ein Spenderstoff und gegebenenfalls ein Aktivator angeordnet. Die Beschichtungskästen werden dann auf eine jeweils geeignete Temperatur erwärmt, wobei der Innenraum mit einem Betriebsgas beaufschlagt wird. Aus dem Spenderstoff und gegebenenfalls dem Betriebsgas und/oder dem Aktivator bzw. Aktivatorgas wird ein Beschichtungsgas gebildet, das auf der Oberfläche der Werkstücke eine Feststoffkomponente als Beschichtung abscheidet.

Als nachteilig an den bisherigen Vorrichtungen und Verfahren ist der Umstand anzusehen, dass nur vergleichsweise geringere Stückzahlen an Werkstücken gleichzeitig beschichtet werden können. Darüber hinaus besitzt jede Beschichtungscharge eine relativ hohe Gesamtmasse, was die Handhabung und Automatisierung erschwert. Zudem führt der Spenderstoff zu Legierungsveränderungen des Kastenmaterials. Schließlich weist insbesondere der als unterster Kasten verwendete Beschichtungskasten eine verkürzte Lebensdauer auf, da er die darüber liegende Last tragen muss, was zu Verformungen führt.

Aufgabe der vorliegenden Erfindung ist es, eine Vorrichtung zu schaffen, die eine verbesserte Durchführung einer Gasphasenbeschichtung von Werkstücken ermöglicht besitzt. Eine weitere Aufgabe der Erfindung ist es, ein entsprechend verbessertes Verfahren zum Gasphasenbeschichten von Werkstücken zu schaffen.

Die Aufgaben werden erfindungsgemäß durch eine Vorrichtung mit den Merkmalen des Patentanspruchs 1 sowie durch ein Verfahren gemäß Patentanspruch 10 gelöst. Vorteilhafte Ausgestaltungen mit zweckmäßigen Weiterbildungen der Erfindung sind in den jeweiligen Unteransprüchen angegeben, wobei vorteilhafte Ausgestaltungen der Vorrichtung als vorteilhafte Ausgestaltungen des Verfahrens und umgekehrt anzusehen sind.

Ein erster Aspekt der Erfindung betrifft eine Vorrichtung zum Gasphasenbeschichten von Werkstücken. Die Vorrichtung weist erfindungsgemäß einen Beschichtungskasten, wenigstens zwei Werkstückauflagen zum Anordnen der Werkstücke in unterschiedlichen Niveaus des Beschichtungskastens, eine Halteeinrichtung, mittels welcher die wenigstens zwei Werkstückauflagen in einem vorbestimmten Abstand zueinander im Beschichtungskasten angeordnet sind und ein Deckelelement, mittels welchem der Beschichtungskasten reversibel verschließbar ist und welches eine Öffnung für eine Gaszuführungseinrichtung, mittels welcher ein Betriebsgas in den Beschichtungskasten einbringbar ist, umfasst, auf. Weiterhin umfasst die erfindungsgemäße Vorrichtung mindestens einen Behälter für einen Spenderstoff, welcher beim Gasphasenbeschichten ein Beschichtungsgas bildet, wobei der mindestens eine Behälter einen direkten Kontakt zwischen dem Spenderstoff und dem Beschichtungskasten verunmöglicht. Im Unterschied zum Stand der Technik ist es somit nicht erforderlich, mehrere Beschichtungskästen einzeln mit Werkstücken zu versehen und übereinanderzustapeln. Stattdessen können die Werkstücke über die zwei, drei, vier, fünf, sechs, sieben oder mehr Werkstückauflagen in unterschiedlichen Ebenen angeordnet werden, wonach die Halteeinrichtung zusammen mit den Werkstückauflagen und den zu beschichtenden Werkstücken in einen einzigen Beschichtungskasten eingesetzt wird, der dann mit dem Deckelelement verschlossen werden kann. Die Einleitung des Betriebsgases, welches auch ein Aktivatorgas umfassen bzw. aus einem Aktivatorgas bestehen kann, in den Beschichtungskasten kann dann durch Einsetzen der Gaszuführungsrichtung durch die Öffnung im Deckelelement erfolgen. Die Möglichkeit der Zuleitung eines Aktivatorgases als Betriebsgas und/oder die Zuleitung eines mit wenigstens einem anderen Gas gemischten Aktivatorgases als Betriebsgas stellt eine wichtige Steuer- bzw. Regelmöglichkeit für den Beschichtungsvorgang dar. Durch den modularen Aufbau der erfindungsgemäßen Vorrichtung ist eine einfache Anpassung an unterschiedliche Gasphasenbeschichtungsverfahren und Werkstücke möglich. Weiterhin ist bei der erfindungsgemäßen Vorrichtung eine höhere Lebensdauer des Beschichtungskastens ermöglicht, da der Spenderstoff, der in einem, zwei, drei, vier, fünf, sechs, sieben oder mehr Behältern angeordnet sein kann, nicht unmittelbar im Beschichtungskasten, sondern in seinem zugeordneten Behälter anordenbar ist. Der betreffende Behälter verhindert damit einen direkten Kontakt des Spenderstoffs mit dem Material des Beschichtungskastens. Durch werden Materialveränderungen des Beschichtungskastens besser verhindert, wodurch auch dessen Festigkeitseigenschaften länger erhalten bleiben. Generell kann vorgesehen sein, dass der Spenderstoff mehrere Verbindungen umfasst und/oder dass mehrere unterschiedliche Spenderstoffe vorgesehen sind. Generell sind "ein/eine" im Rahmen dieser Offenbarung als unbestimmte Artikel zu lesen, also ohne ausdrücklich gegenteilige Angabe immer auch als "mindestens ein/mindestens eine". Umgekehrt können "ein/eine" auch als "nur ein/nur eine" verstanden werden.

In einer vorteilhaften Ausgestaltung der Erfindung ist vorgesehen, dass der mindestens eine Behälter an einer Unterseite wenigstens einer Werkstückauflage und/oder des Deckelelements angeordnet ist. Hierdurch kann das Beschichtungsgas in unmittelbarer Nähe zum zu beschichtenden Werkstück erzeugt werden, was die Beschichtungsqualität verbessert und das Beschichtungsverfahren verkürzt. Indem der mindestens eine Behälter kreisringförmig ausgebildet ist, wird eine entsprechend symmetrische Temperaturverteilung sichergestellt. Damit wird verhindert, dass das Beschichtungsgas an kühleren Stellen auskondensiert und damit für das Beschichtungsverfahren verloren ist. Darüber hinaus kann hierdurch die Gaszuführungseinrichtung durch eine zentrale Öffnung im Behälter geführt werden, wodurch das Betriebsgas gleichmäßig innerhalb des Beschichtungskastens bzw. auf den zwei oder mehr Ebenen in den Beschichtungskasten eingebracht werden kann. Alternativ oder zusätzlich weist der Beschichtungskasten wenigstens eine Verstärkungsrippe auf, wodurch einem Verzug des Behälters vorgebeugt werden kann. Zusätzlich kann der Behälter durch die Verstärkungsrippe(n) in zwei oder mehr Kompartimente unterteilt sein, so dass eine gleichmäßige Verteilung des Spenderstoffs und/oder die Verwendung unterschiedlicher Spenderstoffe erleichtert werden. Alternativ oder zusätzlich umfasst der Behälter wenigstens eine Montageöffnung, in welcher eine Werkstückauflage eingesetzt ist. Hierdurch wird eine zuverlässige Ausrichtung von Behälter und Werkstückauflage zueinander sichergestellt. Zusätzlich kann die Werkstückauflage ein Herausfallen des Spenderstoffs verhindern. Der Behälter und die Werkstückauflage können hierdurch zudem besonders einfach gemeinsam an der Halteeinrichtung festgelegt und gemeinsam mit dieser in den Beschichtungskasten eingesetzt und aus dem Beschichtungskasten entnommen werden.

Weitere Vorteile ergeben sich, indem der mindestens eine Behälter einen Führungskanal umfasst, in welchen die Gaszuführungseinrichtung zum Gasphasenbeschichten zumindest bereichsweise einführbar ist. Hierdurch kann das Betriebsgas in unmittelbarer Nähe zum Spenderstoff eingebracht werden, wodurch eine vorteilhafte Bildung und gleichmäßige Verteilung des Beschichtungsgases im Beschichtungskasten ermöglicht ist. Vorzugsweise verläuft eine Achse des Führungskanals im eingesetzten Zustand in den Beschichtungskasten senkrecht zu einem Boden des Beschichtungskastens. Ebenso kann vorgesehen sein, dass der Führungskanal mit der Öffnung im Deckelelement fluchtet, wodurch die Gaszuführungseinrichtung entsprechend sicher und einfach in den Beschichtungskasten eingeführt und im Führungskanal angeordnet werden kann.

In einer weiteren vorteilhaften Ausgestaltung der Erfindung ist vorgesehen, dass der Führungskanal eine Mehrzahl an Durchtrittsöffnungen für das Betriebsgas aufweist. Dies erleichtert ein möglichst gleichmäßiges Einbringen des Betriebsgases gegebenenfalls über die gesamte Höhe des Beschichtungskastens. Dabei hat es sich als vorteilhaft gezeigt, wenn der Führungskanal durch ein Rohr gebildet wird, das aus einem keramischen Werkstoff und/oder aus einer Nickelbasislegierung besteht. Hierdurch können nicht nur inerte, sondern auch reaktive Betriebsgase in den Beschichtungskasten eingebracht werden, ohne den Führungskanal zu beschädigen.

In einer weiteren vorteilhaften Ausgestaltung der Erfindung ist vorgesehen, dass der Beschichtungskasten einen gebördelten und/oder tellerförmigen Boden und/oder wenigstens eine Sicke im Bereich seines oberen Rands besitzt und/oder dass das Deckelelement tellerförmig ausgebildet ist. Der gebördelte Boden bzw. ein Tellerboden beugt einem Verzug des Beschichtungskastens durch die wechselnden Temperaturen vor. Entsprechend gewährleisten eine oder mehrere Sicken am oberen Rand des Beschichtungskastens dessen mechanische und geometrische Stabilität. Ein als Tellerboden ausgeführtes Deckelelement zentriert den Rand des Beschichtungskastens und trägt damit ebenfalls zur mechanischen und geometrischen Stabilität bei. Zusätzlich kann hierdurch eine Selbstzentrierung des Deckelelements gegenüber dem Beschichtungskasten erreicht werden, was ein entsprechend zuverlässiges Einbringen der Gaszuführungseinrichtung sicherstellt.

Weitere Vorteile ergeben sich, wenn die Halteeinrichtung mindestens zwei und vorzugsweise drei Säulen umfasst, welche vorzugsweise durch korrespondierende Montageöffnungen der Werkstückauflagen geführt sind. Die Säulen dienen zur einfachen Anordnung und Festlegung der Werkstückauflagen in ihren jeweiligen Ebenen. Darüber hinaus können die Säulen beim Transport der Halteeinrichtung in und aus dem Beschichtungskasten im Wesentlichen nur auf Zug belastet werden, wenn die Halteeinrichtung zum Transport an den Endbereichen der Säulen angegriffen wird. Vorzugsweise ist die Länge der Säulen so gewählt, dass die Säulen im im Beschichtungskasten angeordneten Zustand der Halteeinrichtung über den Beschichtungskasten hinausragen bzw. länger sind als der Beschichtungskasten. Damit ist der Bereich, an dem die Säulen beispielsweise über einen Seilzug oder andere Aufhängevorrichtung angegriffen werden können, nur gering durch das Beschichtungsverfahren beeinträchtigt. Offenliegende Abschnitte der Säulen können während des Beschichtens generell maskiert und geschützt werden, beispielsweise durch Hülsen.

In einer weiteren vorteilhaften Ausgestaltung der Erfindung ist vorgesehen, dass die Halteeinrichtung mindestens zwei Abstandshülsen umfasst, mittels welchen das Niveau der Werkstückauflagen im Beschichtungskasten eingestellt ist. Mit anderen Worten stützt sich eine in einer höheren Ebene angeordnete Werkstückauflage über die zwei, drei, vier, fünf oder mehr Abstandshülsen an der darunterliegenden Werkstückauflage ab. Über die Höhe der Abstandshülsen kann damit der relative Abstand benachbarter Werkstückauflagen besonders einfach und bedarfsgerecht eingestellt werden. Zusätzlich können die Abstandshülsen zum Maskieren von Oberflächenbereichen der Säulen verwendet werden.

In einer weiteren vorteilhaften Ausgestaltung der Erfindung ist vorgesehen, dass der Beschichtungskasten und/oder das Deckelelement aus einem hochwarmfesten Stahl, insbesondere aus X15, und/oder aus einer Nickelbasislegierung, insbesondere aus IN625 und/oder C263, besteht. Hierdurch ist eine hohe Hitzebeständigkeit bei gleichzeitig hoher mechanischer und chemischer Stabilität gegeben.

Weitere Vorteile ergeben sich dadurch, dass die Werkstückauflagen und/oder der mindestens eine Behälter zumindest bereichsweise aus einem oder mehreren Materialien aus der Gruppe Metalle, Metalllegierungen, faserverstärkte Verbundwerkstoffe, insbesondere kohlenstofffaserverstärkte Kohlenstoffe und/oder faserverstärkte keramische Werkstoffe, und Metall-Keramik-Verbundwerkstoffe besteht und/oder zumindest bereichsweise mit einem keramischen Material beschichtet ist. Hierdurch können das Gewicht und die chemischen Eigenschaften der Werkstückauflagen und/oder des mindestens einen Behälter optimal an den jeweiligen Einsatzzweck angepasst werden. Insbesondere kann eine Beschädigung der Werkstückauflagen und/oder des mindestens einen Behälter durch die im Rahmen des Beschichtungsverfahrens verwendeten Chemikalien sowie ein Ansintern oder -haften der zu beschichtenden Werkstücke verhindert werden.

Ein zweiter Aspekt der Erfindung betrifft ein Verfahren zum Gasphasenbeschichten von Werkstücken. Erfindungsgemäß umfasst das Verfahren zumindest die Schritte Bereitstellen eines Beschichtungskastens, Bereitstellen von wenigstens zwei Werkstückauflagen, Bereitstellen einer Halteeinrichtung, wobei die wenigstens zwei Werkstückauflagen mittels der Halteeinrichtung in einem vorbestimmten Abstand zueinander angeordnet werden, Anordnen wenigstens eines zu beschichtenden Werkstücks auf wenigstens einer der Werkstückauflagen, Bereitstellen mindestens eines Behälters mit einem Spenderstoff, welcher beim Gasphasenbeschichten ein Beschichtungsgas bildet, Einsetzen des mindestens einen Behälters und der Halteeinrichtung mit den Werkstückauflagen und dem wenigstens einen Werkstück in den Beschichtungskasten, wobei der mindestens eine Behälter einen direkten Kontakt zwischen dem Spenderstoff und dem Beschichtungskasten verunmöglicht, Verschließen des Beschichtungskastens mit einem Deckelelement, Einbringen einer Gaszuführungseinrichtung für ein Betriebsgas durch eine Öffnung im Deckelelement in den Beschichtungskasten, Erwärmen des Beschichtungskastens auf eine vorbestimmte Temperatur, Einbringen des Betriebsgases in den Beschichtungskasten und Erzeugen des Beschichtungsgases aus dem Spenderstoff und Gasphasenbeschichten des wenigstens einen Werkstücks mittels des Beschichtungsgases für eine vorbestimmte Zeitdauer. Im Unterschied zum Stand der Technik ist es somit nicht erforderlich, mehrere Beschichtungskästen einzeln mit Werkstücken zu versehen und übereinanderzustapeln. Stattdessen können ein oder mehrere Werkstücke in den zwei, drei, vier, fünf, sechs, sieben oder mehr Werkstückauflagen in unterschiedlichen Ebenen angeordnet werden, wonach die Halteeinrichtung zusammen mit den Werkstückauflagen und den zu beschichtenden Werkstücken in den Beschichtungskasten eingesetzt wird, der dann mit dem Deckelelement verschlossen wird. Die Einleitung des Betriebsgases in den Beschichtungskasten erfolgt nach dem Einsetzen der Gaszuführungsrichtung durch die Öffnung im Deckelelement. Das Betriebsgas kann generell eine Reinsubstanz oder ein Gemisch mehrerer Verbindungen sein. Weiterhin kann das Betriebsgas generell einen gasförmigen Aktivator umfassen oder aus einem Aktivatorgas bestehen. Das Erwärmen des Beschichtungskastens kann beispielsweise durch Einsetzen des Beschichtungskastens in einen Ofen erfolgen. Aber auch andere Arten der Heizung sind denkbar. Weiterhin ermöglicht das Verfahren eine höhere Lebensdauer des Beschichtungskastens, da der Spenderstoff, der in einem, zwei, drei, vier, fünf, sechs, sieben oder mehr Behältern angeordnet wird, nicht im direkten Kontakt mit dem Material des Beschichtungskastens steht. Durch die Vermeidung von Materialveränderungen des Beschichtungskastens bleiben auch dessen Festigkeitseigenschaften länger erhalten. Generell kann vorgesehen sein, dass der Spenderstoff mehrere Verbindungen umfasst und/oder dass mehrere unterschiedliche Spenderstoffe verwendet werden. Das erfindungsgemäße Verfahren kann aus den genannten Schritten bestehen oder weitere Schritte umfassen. Beispielsweise kann der Beschichtungskasten vor, während und/oder nach dem Gasphasenbeschichten mit einem Waschgas gespült und/oder ein- oder mehrmals evakuiert werden, um Feuchtigkeit zu vertreiben oder Reste des Beschichtungsgases oder anderer Reaktionsprodukte zu entfernen. Weiterhin ist dem Fachmann klar, dass die angegebene Schrittabfolge grundsätzlich variiert werden kann. Beispielsweise kann das Einbringen des Betriebsgases vor, während und/oder nach dem Erwärmen des Beschichtungskastens erfolgen. Die vorbestimmte Zeitdauer hängt generell von der Art des Gasphasenbeschichtungsverfahrens, den gewählten Verfahrensparametern, der gewünschten Schichtdicke, der zu beschichtenden Oberfläche etc. ab und beträgt üblicherweise zwischen wenigen Minuten und mehreren Stunden, wobei auch kürzere oder längere Zeitdauern denkbar sind.

In einer vorteilhaften Ausgestaltung der Erfindung umfasst das Erzeugen des Beschichtungsgases aus dem Spenderstoff die Verwendung eines Aktivators. Als Aktivatoren können geeignete feste und/oder gasförmige Verbindungen, insbesondere Halogenverbindungen und vorzugsweise Chlorid-Verbindungen eingesetzt werden, beispielsweise Chromchloride (Cr3C1). Generall kann es vorgesehen sein, dass das Beschichtungsgas durch Verwendung bzw. Zuführung oder Zumischung von HCl-Gas als Aktivatorgas erzeugt wird. Allerdings besitzen manche Metallchloride, beispielsweise Kobaltchloride, sehr geringe Dampfdrücke, so dass in manchen Fällen keine ausreichende Menge des Chlorids an die Oberfläche des zu beschichtenden Werkstücks transportiert wird. Mit Bromid- und/oder Fluorid-Verbindungen als Aktivatoren bzw. Aktivatorgase können aber auch solche Metalle angereichert werden.

Weitere Vorteile ergeben sich, indem das Gasphasenbeschichten ein Chromieren und/oder ein Alitieren umfasst. Chromieren erfolgt üblicherweise bei Temperaturen zwischen etwa 1000 °C und 1200 °C, beispielsweise bei 1080 °C. Dabei diffundiert abgeschiedenes Chrom in die Randschicht des beschichteten Werkstücks ein und reichert sich an. Chromierungen eignen sich insbesondere bei Werkstücken, die hohen Temperaturen sowie einer aggressiven Umgebung ausgesetzt sind, wie beispielsweise Turbinenschaufeln. Beim Alitieren, das auch als Aluminieren bezeichnet wird, werden aluminiumhaltige Beschichtungen auf dem Werkstück erzeugt. Dabei entstehen harte, zunderbeständige, Al₂O₃-haltige Schichten, unter denen sich im Fall eisenhaltiger Werkstücke bzw. in Anwesenheit von Eisen zusätzlich eine intermetallische Fe-Al-Schicht bilden kann.

In einer weiteren vorteilhaften Ausgestaltung der Erfindung ist vorgesehen, dass ein Ausgangsgewicht wenigstens eines zu beschichtenden Werkstücks vor dem Gasphasenbeschichten und ein Endgewicht des Werkstücks nach dem Gasphasenbeschichten ermittelt werden und eine Beschichtungsqualität anhand einer Differenz zwischen dem Endgewicht und dem Ausgangsgewicht charakterisiert wird. Mit anderen Worten ist es vorgesehen, dass der Beschichtungserfolg anhand der Gewichtszunahme des betreffenden Werkstücks ermittelt wird. Hierzu werden einzelne, mehrere oder alle Werkstücke, pro Ebene oder stichprobenweise, vor und nach der Beschichtung gewogen. Eine metallographische Untersuchung ergibt für eine konkrete Ausgestaltung des Verfahrens den Zusammenhang von Schichtqualität und Gewichtszunahme. Im Serienbetrieb kann dann auf solche metallographischen Untersuchung verzichtet und eine Differenzwägung zur Qualitätsprüfung verwendet werden. Zur Sicherheit können grundsätzlich ein oder mehrere Proben bei der Gasphasenbeschichtung mitgefahren werden. Weiterhin können statistische Auswertungen der Gewichtsdifferenzen, der Schichtdicken und/oder der Gleichmäßigkeit der Schichtdicken über das Werkstück zur Kontrolle des Erfolgs der Gasphasenbeschichtung herangezogen werden.

Weitere Vorteile ergeben sich, indem als Betriebsgas wenigstens ein Gas aus der Gruppe HCl, H₂, HF, N₂, O₂, He, Ne, Kr und Ar verwendet wird. Das Betriebsgas kann generell ein einzelnes Gas oder ein Gasgemisch sein. Hierdurch kann wahlweise eine inerte oder eine reaktive Atmosphäre im Beschichtungskasten erzeugt werden, wodurch unterschiedliche Gasphasenbeschichtungsverfahren durchgeführt werden können. Weiterhin ist es hierdurch möglich, den Beschichtungskasten mit dem Betriebsgas zu spülen.

In einer weiteren vorteilhaften Ausgestaltung der Erfindung ist es vorgesehen, dass als Spenderstoff ein insbesondere chromhaltiges Granulat und/oder ein Pulver, insbesondere Al-Pulver und/oder Al-Fe-Pulver, verwendet wird. Dies erlaubt es, den Spenderstoff in für das konkrete Gasphasenbeschichtungsverfahren optimaler Form bereitzustellen.

Weitere Merkmale der Erfindung ergeben sich aus den Ansprüchen, den Figuren und der Figurenbeschreibung. Die vorstehend in der Beschreibung genannten Merkmale und Merkmalskombinationen, sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen verwendbar, ohne den Rahmen der Erfindung zu verlassen. Es sind somit auch Ausführungen von der Erfindung als umfasst und offenbart anzusehen, die in den Figuren nicht explizit gezeigt und erläutert sind, jedoch durch separierte Merkmalskombinationen aus den erläuterten Ausführungen hervorgehen und erzeugbar sind. Es sind auch Ausführungen und Merkmalskombinationen als offenbart anzusehen, die somit nicht alle Merkmale eines ursprünglich formulierten unabhängigen Anspruchs aufweisen. Es sind darüber hinaus Ausführungen und Merkmalskombinationen, insbesondere durch die oben dargelegten Ausführungen, als offenbart anzusehen, die über die in den Rückbezügen der Ansprüche dargelegten Merkmalskombinationen hinausgehen oder von diesen abweichen. Dabei zeigt:
- Fig. 1: eine schematische Schnittansicht einer erfindungsgemäßen Vorrichtung zum Gasphasenbeschichten von Werkstücken gemäß einem ersten Ausführungsbeispiel;
- Fig. 2: eine schematische Schnittansicht der erfindungsgemäßen Vorrichtung zum Gasphasenbeschichten von Werkstücken gemäß einem zweiten Ausführungsbeispiel;
- Fig. 3: eine schematische Schnittansicht der erfindungsgemäßen Vorrichtung zum Gasphasenbeschichten von Werkstücken gemäß einem dritten Ausführungsbeispiel; und
- Fig. 4: eine schematische Schnittansicht der erfindungsgemäßen Vorrichtung zum Gasphasenbeschichten von Werkstücken gemäß einem vierten Ausführungsbeispiel.

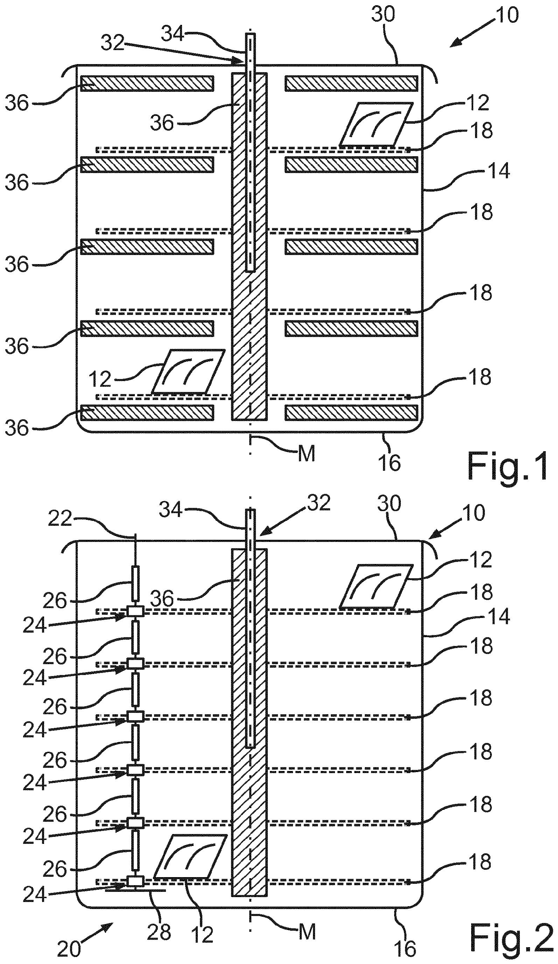

**Fig. 1** zeigt eine schematische Schnittansicht einer erfindungsgemäßen Vorrichtung 10 zum Gasphasenbeschichten von Werkstücken 12 gemäß einem ersten Ausführungsbeispiel. Bei den Werkstücken 12 handelt es sich vorliegend exemplarisch um Turbinenbauteile eines Flugtriebwerks. Die Vorrichtung 10 umfasst einen Beschichtungskasten 14, der im Wesentlichen rotationssymmetrisch aus einem Nickelbasiswerkstoff (IN625) ausgebildet ist und einen tellerförmigen, gebördelten Boden 16 aufweist. Der gebördelte Tellerboden 16 beugt einem Verzug des Beschichtungskastens 14 vor. Weiterhin umfasst die Vorrichtung 10 vorliegend vier Werkstückauflagen 18, welche zum Anordnen der Werkstücke 12 in unterschiedlichen Niveaus des Beschichtungskastens 14 dienen. Sowohl die Anzahl und Anordnung der Werkstücke 12 als auch die der Werkstückauflagen 18 ist rein exemplarisch und kann variiert werden, wobei generell zumindest zwei Werkstückauflagen 18 vorhanden sind. Die Vorrichtung 10 umfasst weiterhin eine Halteeinrichtung 20, die aus Gründen der Übersichtlichkeit nur in **Fig. 2** dargestellt, aber analog im in Fig. 1 gezeigten Ausführungsbeispiel ausgestaltet ist. Die Halteeinrichtung 20 umfasst im in Fig. 2 gezeigten Beispiel drei Säulen 22, von denen lediglich eine dargestellt ist. Die Säulen 22 sind in Form eines gleichseitigen Dreiecks um eine Mittelachse M des Beschichtungskastens 14 angeordnet und durch entsprechende Montageöffnungen 24 in den Werkstückauflagen 18 geführt. Der Abstand zwischen den einzelnen Werkstückauflagen 18 und damit ihre Lage bzw. Ebene im Beschichtungskasten 14 wird durch austauschbare Abstandshülsen 26 der Halteeinrichtung 20 definiert, die über die Säulen 22 geschoben werden und auf denen die darüber liegenden Werkstückauflagen 18 ruhen. Die Abstandshülsen 26 können beispielsweise aus Graphit bestehen. Darüber hinaus maskieren die Abstandshülsen 26 die ansonsten freiliegenden Bereiche der Säulen 22, so dass die Säulen 22 nicht mitbeschichtet und wiederverwendet werden können. Jede Säule 22 umfasst an ihrem bodenseitigen Endbereich einen Flansch 28, auf dem alle darüberliegenden Bauteile abgestützt sind. Alternativ können die Säulen 22 fest mit der untersten Werkstückauflage 18 verbunden sein, so dass diese als eine Art Tragrost fungiert. Die Säulen 22 tragen damit alle weiteren, zusammen ein Chargiergestell bildenden Bauteile und Werkstücke 12. Beim Transport in den Beschichtungskasten 14 und aus dem Beschichtungskasten 14 heraus sind die Säulen 22 vorteilhaft nur auf Zug belastet.

Der Beschichtungskasten 14 weist optionale Sicken (nicht dargestellt) an seinem oberen Rand auf, durch welche die Rundheit des Randes gewährleistet wird. Weiterhin umfasst die Vorrichtung 10 ein Deckelelement 30, mittels welchem der Beschichtungskasten 14 nach der Bestückung verschlossen wird. Das Deckelelement 30 ist im Wesentlichen tellerförmig ausgebildet, so dass sich das Deckelelement 30 automatisch gegenüber dem Beschichtungskasten 14 zentriert und zur Rundheit der Vorrichtung 10 beiträgt. Weiterhin weist das Deckelelement 30 eine Öffnung 32 für eine Gaszuführungseinrichtung 34 auf, mittels welcher ein Betriebsgas in den Beschichtungskasten 14 einbringbar ist. Die vom Beschichtungskasten 14 unabhängige Gaszuführungseinrichtung 34 ist in den gezeigten Ausführungsbeispielen ein Rohr aus einer Nickelbasislegierung und kann bedarfsweise mit mehreren Gasquellen sowie mit einem Kastenspülsystem (nicht gezeigt) verbunden werden. Im eingesetzten Zustand kann das Rohr der Gaszuführungseinrichtung 34 auf einer frei wählbaren Höhe des Beschichtungskastens 14 enden. Weiterhin kann die Gaszuführungseinrichtung 34 eine oder mehrere Querbohrungen zum Gasauslass aufweisen, um das Betriebsgas gegebenenfalls über eine bestimmte Höhe möglichst gleichmäßig in den Beschichtungskasten 14 einzubringen.

Die Säulen 22 ragen vorzugsweise über den Beschichtungskasten 14 hinaus in die Wölbung des Deckelelements 30 hinein. Damit ist der Bereich, an dem eine Aufhängevorrichtung zum Einbringen und Herausnehmen der Säulen 22 und aller von diesen getragenen Bauteilen angeschlagen werden kann, nicht oder nur gering durch das Beschichtungsverfahren betroffen. Dieser Bereich kann während des Beschichtens zusätzlich durch Abdeckhülsen 26 geschützt werden.

Wie man in Fig. 1 sieht, umfasst die Vorrichtung 10 zusätzlich mehrere Behälter 36, in denen Spenderstoff, welcher beim Gasphasenbeschichten ein Beschichtungsgas bildet, angeordnet ist. Die Behälter, die einen direkten Kontakt zwischen dem Spenderstoff und dem Beschichtungskasten 14 verhindern und dadurch Legierungsveränderungen des Kastenmaterials verhindern und die Festigkeitseigenschaften des Beschichtungskastens 14 bewahren, sind unterhalb aller Werkstückauflagen 18 sowie unterhalb des Deckelelements 30 angeordnet. Es versteht sich, dass natürlich trotzdem Spenderstoff ohne eigenen Behälter 36 direkt auf dem Boden 16 des Beschichtungskastens 14 angeordnet werden könnte. Dies ist aber weder erforderlich, noch bevorzugt, da es hierdurch rasch zu Materialveränderungen und einer Beschädigung des Beschichtungskastens 14 kommt. Die Werkstückauflagen 18 sind vorliegend gitterförmig und im Wesentlichen in Form von Kreisringen ausgestaltet und liegen in jeweiligen Montageöffnungen auf Verstärkungsrippen der ebenfalls kreisringförmigen Behälter 36 auf. Dadurch entsteht das Beschichtungsgas in unmittelbarer Nähe zu den Werkstücken 12. Zusätzlich ist ein weiterer Behälter 36 mit Spenderstoff entlang der Mittelachse M angeordnet und erstreckt sich damit durch die zentralen Öffnungen der Werkstückauflagen 18 und Behälter 36. Dieser Behälter 36 ist durch ein äußeres Lochblech begrenzt und weist ein zentrales Führungsrohr (nicht gezeigt) aus Keramik auf, in dem das Rohr der Gaszuführungseinrichtung 34 aufgenommen ist. Das Führungsrohr weist seinerseits mehrere Querbohrungen zur Verteilung des Betriebsgases auf. Durch den modularen Aufbau der Vorrichtung 10 können die einzelnen Bauteile einfach ausgetauscht und gegebenenfalls ersetzt werden.

Als Spenderstoff kann für ein Chromierungsverfahren beispielsweise ein Cr-Granulat (Ceral 20) verwendet werden. Die Gaszuführungseinrichtung 34 kann dann dazu verwendet werden, ein Betriebsgasgemisch aus H2 / HCl an das Cr-Granulat in den Behältern 36 heranzuführen. Aus HCl und Chrom bildet sich bei entsprechend hohen Temperaturen von etwa 1080 °C CrCl-Gas als Beschichtungsgas, das sich dann auf den Werkstücken 12 zu einer Chromschicht zersetzt.

Zur Qualitätssicherung werden die Werkstücke 12 alle, manche, pro Ebene eines oder stichprobenweise vor und nach der Beschichtung gewogen. Eine metallographische Untersuchung ergibt den Zusammenhang von Schichtqualität und Gewichtszunahme. Durch die Differenz zwischen dem Ausgangsgewicht und dem Engewicht kann die Beschichtungsqualität beurteilt werden, wodurch im Serienbetrieb auf metallographische Untersuchungen verzichtet werden kann. Proben können zur Sicherheit mitgefahren werden.

Auch Thermoelemente können grundsätzlich entfallen, wenn die Verfahrensparameter und die Masse der Charge weitgehend konstant bleiben, da die Temperaturgleichmäßigkeit des gezeigten Chargenaufbaues reproduzierbar ist. Die vorher beschriebene Gewichtskontrolle der Werkstücke 12 über Differenzwägungen dokumentiert den Beschichtungserfolg. Mittels statistischer Maßnahmen kann der laufende CVD-Prozess überwacht werden.

Die Behälter 36 und die Werkstückauflagen 18 können aus gleichen oder unterschiedlichen Materialien bestehen. Beispielsweise können beide aus einer Metalllegierung oder aus CFC (Kohlenstofffaserverstärkte Kohlenstoffe, englisch carbon fiber carbon composite, CFC) bestehen. Hierdurch sind diese Bauteile besonders leicht, weisen eine hervorragende Temperaturverteilung durch die gute Wärmeleitfähigkeit von CFCs auf, sind verzugsfrei und häufig verwendbar. Alternativ können die Behälter 36 und/oder Werkstückauflagen 18 aus faserverstärktem Al₂O₃ bestehen. Auch dies führt zu einem geringen Gewicht, Verzugsfreiheit und häufigere Verwendbarkeit.

Zusätzlich wird kein Al₂O₃-Trenn-Schlicker benötigt, um ein Ansintern der Werkstücke 12 zu verhindern.

Zusätzlich zu dem Spenderstoff kann in einem oder mehreren Behältern ein Aktivator, beispielsweise Cr3Cl vorgesehen sein. Der Aktivator kann üblicherweise in Mengen zwischen 80 g und 150 g vorgesehen sein.

Bei einem typischen Chromierverfahren wird der bestückte und verschlossene Beschichtungskasten 14 in einen Ofen transportiert und auf eine Temperatur von 1080 °C erwärmt. Als Spendermaterial kann ein chromhaltiges Granulat wie beispielsweise Ceral 20 verwendet werden. Die Haltezeit beträgt etwa 6 h. Anschließend wird der Beschichtungskasten 14 etwa 1 h gespült und abgekühlt. Als Betriebsgas ist dabei Ar vorgesehen, welches die Retortenatmosphäre schafft. Die Kastenspülung erfolgt mit einem Volumen von etwa 1900 l/h.

Alternativ kann das Gasphasenbeschichtungsverfahren generell ohne Donator (in den einzelnen Ebenen) durchgeführt werden. Hierzu wird bei einer Temperatur von 1080 °C zunächst zwischen 3 h und 12 h HCl, beispielsweise 6 h, mit einem Gasfluss zwischen 10 l/h und 30 l/h als Betriebsgas eingeleitet. Anschließend wird 1 h mit Ar als Betriebsgas gespült.

Mit Hilfe der Vorrichtung 10 sind hohe Stückzahlen möglich. Zusätzlich wird aufgrund des modularen und mehrstöckigen Aufbaus die Gesamtmasse einer Ofenfahrt minimiert. Durch den sehr symmetrischen Aufbau ist eine verbesserte Temperaturverteilung der Beschichtungscharge sichergestellt. Generell ist kein pulver- oder granulatförmiger Aktivator zwingend erforderlich, was zu entsprechenden Vereinfachungen und Kostensenkungen führt. Außerdem kann das Gasphasenbeschichten weitgehend automatisiert werden.

**Fig. 2** zeigt eine schematische Schnittansicht der erfindungsgemäßen Vorrichtung 10 zum Gasphasenbeschichten von Werkstücken gemäß einem zweiten Ausführungsbeispiel. Der generelle Aufbau ist aus der Beschreibung des ersten Ausführungsbeispiels bekannt. Im Unterschied zum ersten Ausführungsbeispiel umfasst die Vorrichtung 10 des zweiten Ausführungsbeispiels sechs Werkstückauflagen 18 und nur einen zentral angeordneten Behälter 36 für den Spenderstoff.

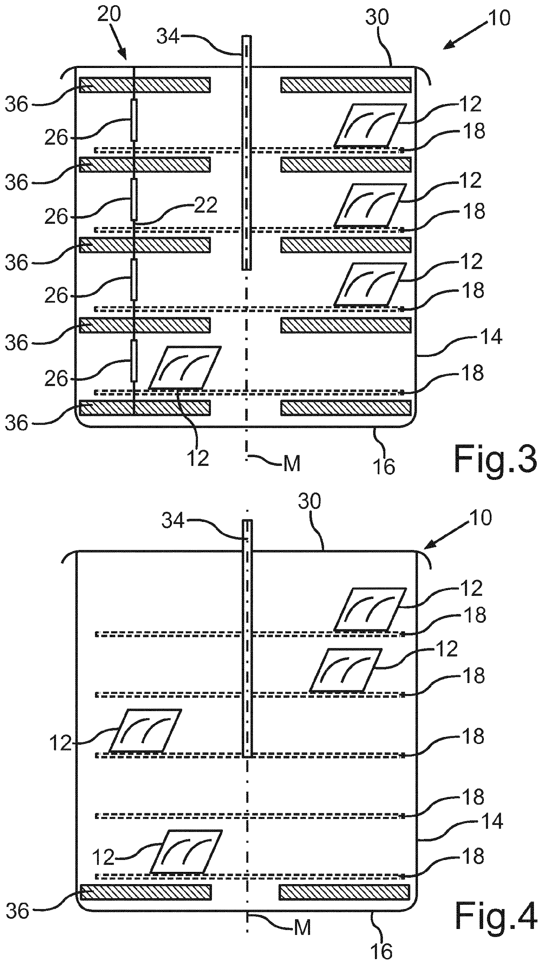

**Fig. 3** zeigt eine schematische Schnittansicht der erfindungsgemäßen Vorrichtung 10 zum Gasphasenbeschichten von Werkstücken gemäß einem dritten Ausführungsbeispiel. Im Unterschied zu den vorherigen Ausführungsbeispielen ist kein zentraler, die Gaszuführungseinrichtung 34 ummantelnder Behälter 36 vorgesehen. Die in Anzahl und Anordnung exemplarischen fünf Behälter 36 sind jeweils unterhalb der Werkstückauflagen 18 bzw. des Deckelelements 30 angeordnet.

**Fig. 4** zeigt eine schematische Schnittansicht der erfindungsgemäßen Vorrichtung 10 zum Gasphasenbeschichten von Werkstücken gemäß einem vierten Ausführungsbeispiel. Auch in diesem Beispiel ist kein zentraler, die Gaszuführungseinrichtung 34 ummantelnder Behälter 36 vorgesehen. Lediglich unterhalb der untersten von fünf Werkstückauflagen 18 ist ein Behälter 36 mit einem Spenderstoff und gegebenenfalls einem Aktivator angeordnet. Es versteht sich, dass zahlreiche weitere Kombinationen und Anordnungsvarianten der Werkstückauflagen 18 und Behälter 36 vorgesehen sein können. Die Spenderstoffmenge kann je nach notwendiger Beschichtungsqualität und zu beschichtender Werkstückoberfläche variiert werden. Die Ebenen der Werkstückauflagen 18 können je nach Bauteilhöhe und Anzahl an zu beschichtenden Werkstücken 12 angepasst werden. Die Einzelteile der Vorrichtung 10 können aus verschiedenen, je nach Einsatzzweck ausgewählten Materialien (z. B. CFC, faserverstärkte Keramik, Metalllegierungen, Keramiken etc.) bestehen.

Die in den Unterlagen angegebenen Parameterwerte zur Definition von Prozess- und Messbedingungen für die Charakterisierung von spezifischen Eigenschaften des Erfindungsgegenstands sind auch im Rahmen von Abweichungen - beispielsweise aufgrund von Messfehlern, Systemfehlern, Einwaagefehlern, DIN-Toleranzen und dergleichen - als vom Rahmen der Erfindung mitumfasst anzusehen.

### Bezugszeichenliste:

- 10: Vorrichtung
- 12: Werkstücke
- 14: Beschichtungskasten
- 16: Boden
- 18: Werkstückauflage
- 20: Halteeinrichtung
- 22: Säule
- 24: Montageöffnungen
- 26: Abstandshülsen
- 28: Flansch
- 30: Deckelelement
- 32: Öffnung
- 34: Gaszuführungseinrichtung
- 36: Behälter
- M: Mittelachse

## Patentansprüche

1. Vorrichtung (10) zum Gasphasenbeschichten von Werkstücken (12), umfassend
- einen Beschichtungskasten (14);
- wenigstens zwei Werkstückauflagen (18) zum Anordnen der Werkstücke (12) in unterschiedlichen Niveaus des Beschichtungskastens (14);
- eine Halteeinrichtung (20), mittels welcher die wenigstens zwei Werkstückauflagen (18) in einem vorbestimmten Abstand zueinander im Beschichtungskasten (14) angeordnet sind;
- ein Deckelelement (30), mittels welchem der Beschichtungskasten (14) reversibel verschließbar ist und welches eine Öffnung (32) für eine Gaszuführungseinrichtung (34), mittels welcher ein Betriebsgas in den Beschichtungskasten (14) einbringbar ist, umfasst; und
- mindestens einen Behälter (36) für einen Spenderstoff, welcher beim Gasphasenbeschichten ein Beschichtungsgas bildet, wobei der mindestens eine Behälter (36) einen direkten Kontakt zwischen dem Spenderstoff und dem Beschichtungskasten (14) verunmöglicht.

2. Vorrichtung (10) nach Anspruch 1,
**dadurch gekennzeichnet, dass**
der mindestens eine Behälter (36) an einer Unterseite wenigstens einer Werkstückauflage (18) und/oder des Deckelelements (30) angeordnet und/oder kreisringförmig ausgebildet ist und/oder wenigstens eine Verstärkungsrippe und/oder wenigstens eine Montageöffnung, in welcher eine Werkstückauflage (18) eingesetzt ist, umfasst.

3. Vorrichtung (10) nach Anspruch 1 oder 2,
**dadurch gekennzeichnet, dass**
der mindestens eine Behälter (36) einen Führungskanal umfasst, in welchen die Gaszuführungseinrichtung (34) zumindest bereichsweise einführbar ist.

4. Vorrichtung (10) nach Anspruch 3,
**dadurch gekennzeichnet, dass**
der Führungskanal eine Mehrzahl an Durchtrittsöffnungen für das Betriebsgas aufweist und/oder dass der Führungskanal durch ein Rohr gebildet wird, das aus einem keramischen Werkstoff und/oder aus einer Nickelbasislegierung besteht.

5. Vorrichtung (10) nach einem der Ansprüche 1 bis 4,
**dadurch gekennzeichnet, dass**
der Beschichtungskasten (14) einen gebördelten und/oder tellerförmigen Boden und/oder wenigstens eine Sicke im Bereich seines oberen Rands besitzt und/oder dass das Deckelelement (30) tellerförmig ausgebildet ist.

6. Vorrichtung (10) nach einem der Ansprüche 1 bis 5,
**dadurch gekennzeichnet, dass**
die Halteeinrichtung (20) mindestens zwei und vorzugsweise drei Säulen (22) umfasst, welche vorzugsweise durch korrespondierende Montageöffnungen der Werkstückauflagen (18) geführt sind.

7. Vorrichtung (10) nach einem der Ansprüche 1 bis 6,
**dadurch gekennzeichnet, dass**
die Halteeinrichtung (20) mindestens zwei Abstandshülsen (26) umfasst, mittels welchen das Niveau der Werkstückauflagen (18) im Beschichtungskasten (14) eingestellt ist.

8. Vorrichtung (10) nach einem der Ansprüche 1 bis 7,
**dadurch gekennzeichnet, dass**
der Beschichtungskasten (14) und/oder das Deckelelement (30) aus einem hochwarmfesten Stahl, insbesondere aus X15, und/oder aus einer Nickelbasislegierung, insbesondere aus IN625 und/oder C263, besteht.

9. Vorrichtung (10) nach einem der Ansprüche 1 bis 8,
**dadurch gekennzeichnet, dass**
die Werkstückauflagen (18) und/oder der mindestens eine Behälter (36) zumindest bereichsweise aus einem oder mehreren Materialien aus der Gruppe Metalle, Metalllegierungen, faserverstärkte Verbundwerkstoffe, insbesondere kohlenstofffaserverstärkte Kohlenstoffe und/oder faserverstärkte keramische Werkstoffe, und Metall-Keramik-Verbundwerkstoffe besteht und/oder zumindest bereichsweise mit einem keramischen Material beschichtet ist.

10. Verfahren zum Gasphasenbeschichten von Werkstücken (12), umfassend die Schritte
- Bereitstellen eines Beschichtungskastens (14);
- Bereitstellen von wenigstens zwei Werkstückauflagen (18);
- Bereitstellen einer Halteeinrichtung (20), wobei die wenigstens zwei Werkstückauflagen (18) mittels der Halteeinrichtung (20) in einem vorbestimmten Abstand zueinander angeordnet werden;
- Anordnen wenigstens eines zu beschichtenden Werkstücks (12) auf wenigstens einer der Werkstückauflagen (18);
- Bereitstellen mindestens eines Behälters (36) mit einem Spenderstoff, welcher beim Gasphasenbeschichten ein Beschichtungsgas bildet;
- Einsetzen des mindestens einen Behälters (36) und der Halteeinrichtung (20) mit den Werkstückauflagen (18) und dem wenigstens einen Werkstück (12) in den Beschichtungskasten, wobei der mindestens eine Behälter (36) einen direkten Kontakt zwischen dem Spenderstoff und dem Beschichtungskasten (14) verunmöglicht;
- Verschließen des Beschichtungskastens (14) mit einem Deckelelement (30);
- Einbringen einer Gaszuführungseinrichtung für ein Betriebsgas durch eine Öffnung (32) im Deckelelement (30) in den Beschichtungskasten (14);
- Erwärmen des Beschichtungskastens (14) auf eine vorbestimmte Temperatur;
- Einbringen des Betriebsgases in den Beschichtungskasten (14) und Erzeugen des Beschichtungsgases aus dem Spenderstoff; und
- Gasphasenbeschichten des wenigstens einen Werkstücks (12) mittels des Beschichtungsgases für eine vorbestimmte Zeitdauer.

11. Verfahren nach Anspruch 10,
**dadurch gekennzeichnet, dass**
das Erzeugen des Beschichtungsgases aus dem Spenderstoff die Verwendung eines Aktivators umfasst.

12. Verfahren nach Anspruch 10 oder 11,
**dadurch gekennzeichnet, dass**
das Gasphasenbeschichten ein Chromieren und/oder ein Alitieren umfasst.

13. Verfahren nach einem der Ansprüche 10 bis 12,
**dadurch gekennzeichnet, dass**
ein Ausgangsgewicht wenigstens eines zu beschichtenden Werkstücks (12) vor dem Gasphasenbeschichten und ein Endgewicht des Werkstücks (12) nach dem Gasphasenbeschichten ermittelt werden und eine Beschichtungsqualität anhand einer Differenz zwischen dem Endgewicht und dem Ausgangsgewicht charakterisiert wird.

14. Verfahren nach einem der Ansprüche 10 bis 13,
**dadurch gekennzeichnet, dass**
als Betriebsgas wenigstens ein Gas aus der Gruppe HCl, H2, HF, N₂, O₂, He, Ne, Kr und Ar verwendet wird.

15. Verfahren nach einem der Ansprüche 10 bis 14,
**dadurch gekennzeichnet, dass**
als Spenderstoff ein insbesondere chromhaltiges Granulat und/oder ein Pulver, insbesondere Al-Pulver und/oder Al-Fe-Pulver, verwendet wird.
